# EUROPEAN PATENT SPECIFICATION

(11) **EP 1 184 419 B1**
(45) Date of publication and mention of the grant of the patent: **11.08.2004**
(21) Application number: 01119692.0
(22) Date of filing: 23.08.2001
(51) Int. Cl.: C08L 63/00, C08L 61/06, H01L 23/29, C08G 59/42, C08G 59/40, H01L 23/00

(54) **Resin composition for selaing semiconductor, semiconductor device using the same semiconductor wafer and mounted structure of semiconductor device**
Harzzusammensetzung zum Abdichten einer Halbleiteranordnung, Gerät die diese Halbleiteranordnung verwendet und Montierungsstruktur dieser Halbleiteranordnung
Composition de résine pour sceller un élément semi-conducteur, dispositif utilisant ce semi-conducteur et structure de montage de cet élément semi-conducteur

(30) Priority: 24.08.2000 JP 2000254026
(43) Date of publication of application: 06.03.2002
(73) Proprietor: NITTO DENKO CORPORATION, Osaka (JP)
(72) Inventor: Harada, Tadaaki, Ibaraki-shi, Osaka (JP)
(74) Representative: HOFFMANN - EITLE

(56) References cited:
- US-A- 5 726 222
- PATENT ABSTRACTS OF JAPAN vol. 013, no. 579 (C-668), 20 December 1989 (1989-12-20) -& JP 01 242616 A (SUMITOMO BAKELITE CO LTD), 27 September 1989 (1989-09-27)
- PATENT ABSTRACTS OF JAPAN vol. 006, no. 094 (C-105), 2 June 1982 (1982-06-02) -& JP 57 023625 A (TOSHIBA CORP), 6 February 1982 (1982-02-06)
- PATENT ABSTRACTS OF JAPAN vol. 014, no. 063 (C-0685), 6 February 1990 (1990-02-06) -& JP 01 287131 A (SUMITOMO BAKELITE CO LTD), 17 November 1989 (1989-11-17)
- PATENT ABSTRACTS OF JAPAN vol. 008, no. 034 (C-210), 15 February 1984 (1984-02-15) -& JP 58 198525 A (SANYUREJIN KK), 18 November 1983 (1983-11-18)
- PATENT ABSTRACTS OF JAPAN vol. 008, no. 071 (C-217), 3 April 1984 (1984-04-03) -& JP 58 225121 A (SANYUREJIN KK), 27 December 1983 (1983-12-27)

## Description

### BACKGROUND OF THE INVENTION

### Field of the Invention

The present invention relates to a resin composition for sealing a semiconductor device, which is an epoxy resin-based sealing material showing a low viscosity at a relatively low temperature of 80°C or less, the resin composition especially being excellent in discharging and coating workability and in storage stability, and a semiconductor device using the resin composition, a semiconductor wafer, and a mounted structure of a semiconductor device.

### Discussion of the Related Art

Conventionally, in the semiconductor sealing by such means of TAB (tape automated bonding) and COB (chip on board), a liquid sealing material has been used. The above-mentioned liquid sealing material is usually used at room temperature (25°C), and a semiconductor device is produced by resin-sealing a semiconductor element by a dispenser or printing. As the liquid sealing material described above, an epoxy resin composition comprising a liquid epoxy resin, an acid anhydride-based curing agent and a usual curing accelerator has been generally known.

However, the liquid sealing material as described above easily liquefies because of the use of the acid anhydride-based curing agent as a curing agent. Consequently, there arise some problems such that the liquid sealing material has a high moisture tolerance ratio, so that its moisture tolerance reliability is impaired, even though the liquid sealing material is poor in dischargeability and coating workability. In addition, the above-mentioned liquid sealing material is poor in storage stability because of being liquid at room temperature, and its viscosity gradually greatly increases during storage at room temperature. Therefore, there is a necessity to provide a special storage means for solidifying the resin by freezing during storage.

In view of the problems described above, an object of the present invention is to provide a resin composition for sealing a semiconductor device which is excellent not only in moisture tolerance reliability and in storage stability but also in dischargeability and coating workability, and a semiconductor device using the resin composition, a semiconductor wafer, and a mounted structure of a semiconductor device.

These and other objects of the present invention will be apparent from the following description.

### SUMMARY OF THE INVENTION

As a result of intensive studies with the aim to obtain a material for sealing a semiconductor device which is excellent not only in moisture tolerance reliability and in storage stability but also in dischargeability and coating workability, the present inventor has found that a desired object can be achieved by using a resin composition comprising an epoxy resin, a phenolic resin and a latent curing accelerator, the resin composition having a specified viscosity at each temperature of 25°C and 80°C for the application of a semiconductor sealing.

Specifically, in a first gist, the present invention provides a resin composition for sealing a semiconductor device comprising:
(A) an epoxy resin;
(B) a phenolic resin; and
(C) a latent curing accelerator,
wherein the resin composition is a solid at 25°C or has a viscosity of not less than 400 Pa•s at 25°C and of not more than 200 Pa•s at 80°C.

Also, a second gist of the present invention provides a semiconductor device comprising:
a wiring circuit substrate;
plural connecting electrodes;
a semiconductor element mounted on the wiring circuit substrate via the plural connecting electrodes; and
a sealing resin layer formed with the resin composition, wherein a gap between the wiring circuit substrate and the semiconductor element is sealed by the sealing resin layer.

Further, a third gist of the present invention provides a semiconductor device comprising:
a wiring circuit substrate;
a semiconductor element mounted on the wiring circuit substrate, wherein the wiring circuit substrate and the semiconductor element are electrically connected; and
an encapsulation resin layer formed with the resin composition defined above, wherein the semiconductor element is incorporated in the encapsulation resin layer, thereby encapsulating the periphery of the semiconductor element.

Moreover, a fourth gist of the present invention provides a mounted structure of a semiconductor device comprising:
an external substrate for mounting;
a semiconductor device mounted on the external substrate for mounting; and
a sealing resin layer formed with the resin composition defined above,
wherein a gap between the external substrate for mounting and the semiconductor device is sealed by the sealing resin layer.

Furthermore, a fifth gist of the present invention provides a semiconductor wafer comprising plural semiconductor elements arranged with projected electrodes on one side of the wafer, and a sealing resin layer having a given thickness made of the resin composition defined above, wherein the sealing resin layer is formed on the projected electrode-arranged side such that at least a tip end of the projected electrodes is exposed from the encapsulation resin layer.

A sixth gist of the present invention provides a semiconductor device comprising:
an external substrate for mounting;
a semiconductor element individually obtained by cutting the semiconductor wafer defined above, wherein the external substrate and the semiconductor element are electrically connected by heat-and-pressure fusing or solder reflow in a state where a resin layer-forming side of the semiconductor element faces the external substrate; and
a sealing resin layer formed between the semiconductor element and the external substrate by thermally curing the resin layer.

A seventh gist of the present invention provides a semiconductor device comprising:
a matrix-like wiring circuit substrate comprising individual wiring circuits;
plural semiconductor elements mounted on the wiring circuit substrate; and
an encapsulation resin layer formed with the resin composition defined above on the entire plural semiconductor elements, wherein the semiconductor element is incorporated in the encapsulation resin layer, thereby encapsulating the periphery of the semiconductor element.

### DETAILED DESCRIPTION OF THE INVENTION

Next, the embodiments of the present invention will be described in detail below.

The resin composition for sealing a semiconductor device (hereinafter simply referred to as "resin composition") of the present invention comprises:
(A) an epoxy resin;
(B) a phenolic resin; and
(C) a latent curing accelerator, which is a microcapsulated curing accelerator comprising a core made of a curing agent and, formed thereon, a shell comprising a polymer having urea bonding,
wherein the resin composition is a solid at 25°C or has given viscosities at each temperature of 25°C or 80°C.

In the resin composition of the present invention, the combinations of the essential constituents the epoxy resin (the component A) and the phenolic resin (the component B) can be roughly classified into the following embodiments by the characteristics of the epoxy resin and the phenolic resin.

The First Embodiment is an embodiment where a liquid epoxy resin as the epoxy resin (the component A) is used in combination with a solid phenolic resin as the phenolic resin (the component B); the Second Embodiment is an embodiment where a solid epoxy resin as the epoxy resin (the component A) is used in combination with a liquid phenolic resin as the phenolic resin (the component B); and the Third Embodiment is an embodiment where a solid epoxy resin as the epoxy resin (the component A) is used in combination with a solid phenolic resin as the phenolic resin (the component B).

Incidentally, an embodiment where a liquid epoxy resin as the epoxy resin (the component A) is used in combination with a liquid phenolic resin as the phenolic resin (the component B) is not preferred as the resin composition of the present invention, because the viscosity is likely to undergo changes during storage at room temperature.

In addition, as to the remaining latent curing accelerator (the component C) and other additives as optional components, those which are in common for all of the above-mentioned three embodiments can be used.

First, the First Embodiment, which is a resin composition comprising a liquid epoxy resin as the epoxy resin (the component A) and a solid phenolic resin as the phenolic resin (the component B), will be described.

The above-mentioned liquid epoxy resin is not particularly limited, as long as it is liquid at 25°C (room temperature), and various epoxy resins can be used. Concrete examples thereof include bisphenol F epoxy resins, bisphenol A epoxy resins, alicyclic epoxy resins, allylated bisphenol epoxy resins, and the like. These liquid epoxy resins can be used alone or in admixture of two or more kinds. Incidentally, the term "liquid epoxy resin" as used herein not only refers to those which are liquid at 25°C when used alone as a matter of course, but also encompasses those which are liquid at 25°C as a final epoxy resin component when used in admixture of two or more kinds.

The above-mentioned liquid epoxy resin in the present invention preferably has an epoxy equivalence of 110 to 220 g/eq., especially an epoxy equivalence of 140 to 200 g/eq.

On the other hand, the above-mentioned solid phenolic resin is not particularly limited, as long as the phenolic resin is capable of acting as a curing agent for the above-mentioned liquid epoxy resin and is solid at 25°C (room temperature), and various phenolic resins can be used. Also, an acid anhydride-based curing agent such as tetrahydrophthalic acid anhydride, hexahydrophthalic acid anhydride, methylhexahydrophthalic acid anhydride, or phthalic anhydride; an amine; and a phthalic acid may be used together therewith in an amount so as not to hinder the desired object of the present invention. Concrete examples of the above-mentioned solid phenolic resin include polyfunctional solid phenolic resins, bisphenol resins, naphthalene phenolic resin, phenol novolak resin, triphenylmethane phenolic resin, terpene phenolic resin, terpene diphenolic resin, dihydroxynaphthalene resins, allylated phenolic resin, acetylated phenolic resins and the like. These solid phenolic resins can be used alone or in admixture of two or more kinds.

Here, the term "polyfunctional solid phenol resin" refers to a solid phenolic resin having at least one aromatic ring having two or more phenolic hydroxyl groups, a total number of phenolic hydroxyl groups in its molecule being 3 or more, and at least two aromatic rings in its molecule. The polyfunctional solid phenol resin includes, for instance, trifunctional solid phenolic resins, tetrafunctional solid phenolic resins, pentafunctional solid phenolic resins, and the like. In the case where the polyfunctional solid phenolic resin is used, those having a number-average molecular weight of 450 or less are preferred. Incidentally, the term "solid phenolic resin" as used herein not only refers to those which are solid at 25°C when used alone as a matter of course, but also encompasses those which are solid at 25°C as a final phenolic resin component when used in admixture of two or more kinds.

Among the above-mentioned solid phenolic resins, the trifunctional solid phenolic resin includes, for instance, phenolic resins each having the structure represented by one of the following general formulas:

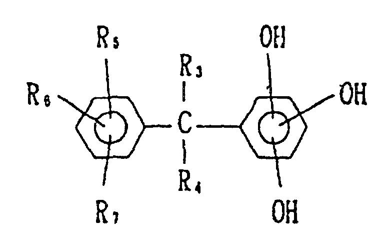

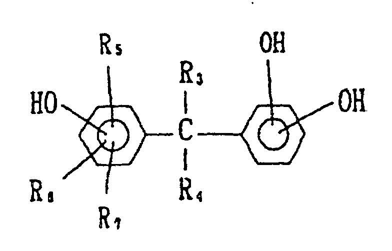

In each of the above-mentioned general formulas, each of R₃ to R₇, which may be identical or different, is hydrogen atom or methyl group.

Among the above-mentioned solid phenolic resins, the tetrafunctional solid phenolic resin includes, for instance, phenolic resins each having the structure represented by the following general formula:

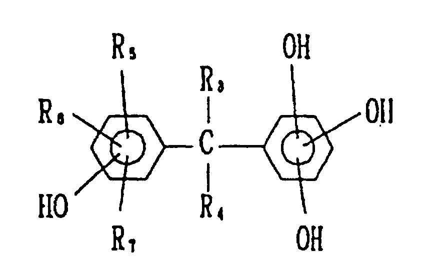

In the above-mentioned general formula, each of R₃ to R₇, which may be identical or different, is hydrogen atom or methyl group.

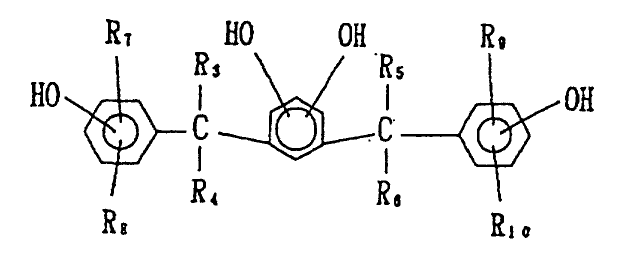

In the above-mentioned general formula, each of R₃ to R_{10,} which may be identical or different, is hydrogen atom or methyl group.

Among the above-mentioned solid phenolic resins, the pentafunctional solid phenolic resin includes, for instance, phenolic resins each having the structure represented by the following general formula:

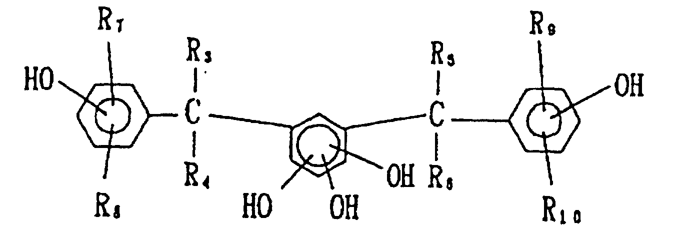

In the above-mentioned general formula, each of R₃ to R₁₀, which may be identical or different, is hydrogen atom or methyl group.

The above-mentioned solid phenolic resin preferably has a hydroxyl group equivalence of 30 to 260 g/eq., and a softening point of 40° to 100°C or a melting point of 50° to 210°C, especially a hydroxyl group equivalence of 50 to 110 g/eq., and a softening point of 60° to 90°C or a melting point of 70° to 190°C.

Also, in the First Embodiment, the formulation proportion of the liquid epoxy resin and the solid phenolic resin is such that the hydroxyl group in the solid phenolic resin is adjusted to preferably 0.6 to 1.4 eq., more preferably 0.7 to 1.1 eq., per one eq. of the epoxy group in the liquid epoxy resin.

In the First Embodiment, in the above-mentioned combination of the liquid epoxy resin with the solid phenolic resin, it is preferable to use, for instance, the combination of the bisphenol F epoxy resin with the polyfunctional solid phenolic resin, from the viewpoints of fluidity, heat resistance and thermosetting property.

Next, the Second Embodiment, which is a resin composition comprising a solid epoxy resin as the epoxy resin (the component A) and a liquid phenolic resin as the phenolic resin (the component B), will be described.

The above-mentioned solid epoxy resin is not particularly limited, as long as the epoxy resin is solid at 25°C (room temperature), and various epoxy resin can be used. Concrete examples of the solid epoxy resin include polyfunctional solid epoxy resins, crystalline epoxy resins, bifunctional solid epoxy resins, triglycidyl isocyanurate, and the like. These solid epoxy resins can be used alone or in admixture of two or more kinds. Here, the term "polyfunctional solid epoxy resin" refers to a solid epoxy resin having a total number of epoxy groups of 3 or more in its molecule. Concrete examples of the polyfunctional solid epoxy resin described above include tetrafunctional naphthalenic epoxy resins, triphenylmethane epoxy resins, dicyclopentadiene epoxy resins, "TECHMORE VG3101L" manufactured by Mitsui Chemical, orthocresol novolak epoxy resins, and the like.

In addition, the term "crystalline epoxy resin" refers to a solid epoxy resin which has a large number of crystal peaks as determined by X-ray diffraction, the epoxy resin has physical characteristics such that the epoxy resin has a sharp melting point by X-ray diffraction, and a dramatically lowered viscosity owing to almost no interactions between the molecules during melting. Concrete examples of the crystalline epoxy resin include bisphenol epoxy resins, biphenyl epoxy resins, stylbene epoxy resins, and the like. Incidentally, the term "solid epoxy resin" as used herein not only to refers those which are solid at 25°C when used alone as a matter of course, but also encompasses those which are solid at 25°C as a final epoxy resin component when used in admixture of two or more kinds.

Among the above-mentioned solid epoxy resins, the tetrafunctional naphthalenic epoxy resin includes, for instance, one commercially available under the trade name of EXA-4701 (manufactured by DAINIPPON INK & CHEMICALS, INC.), which is represented by the following formula:

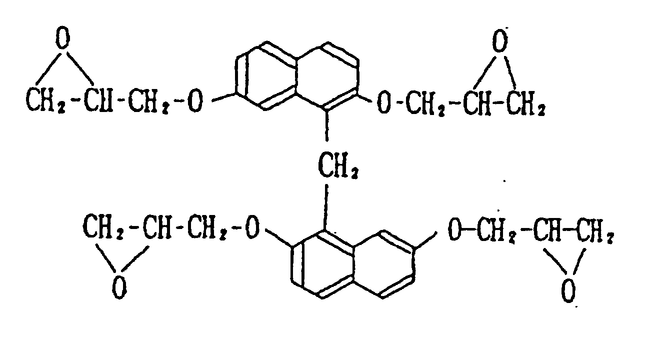

Among the above-mentioned solid epoxy resins, the triphenylmethane epoxy resin includes, for instance, one commercially available under the trade name of EPPN-501HY (manufactured by NIPPON KAYAKU CO., LTD.), which is represented by the following formula:

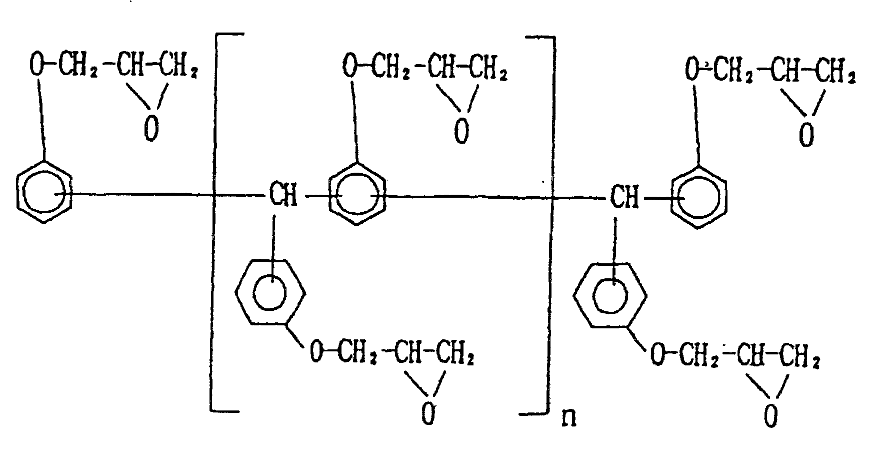

In the formula, n is 0 or a positive number.

The above-mentioned solid epoxy resin preferably has an epoxy equivalence of 140 to 270 g/eq., and a softening point of 50° to 100°C or a melting point of 40° to 150°C, especially an epoxy equivalence of 150 to 220 g/eq., and a softening point of 60° to 80°C or a melting point of 50° to 130°C.

The liquid phenolic resin which is used together with the above-mentioned solid epoxy resin is not particularly limited, as long as the phenolic resin is capable of acting as a curing agent for the above-mentioned liquid epoxy resin and is liquid at 25°C (room temperature), and various phenolic resins can be used. Concrete examples of the above-mentioned liquid phenolic resin include allylated phenol novolak resins, diallylated bisphenol A resins, acetylated phenolic resins, diallylated bisphenol F resins, and the like. These liquid phenolic resins can be used alone or in admixture of two or more kinds. Incidentally, the term "liquid phenolic resin" as used herein not only refers to those which are liquid at 25°C when used alone as a matter of course, but also encompasses those which are liquid at 25°C as a final phenolic resin component when used in admixture of two or more kinds.

The above-mentioned liquid phenolic resin preferably has a hydroxyl group equivalence of 80 to 200 g/eq, especially a hydroxyl group equivalence of 100 to 170 g/eq.

Also, in the Second Embodiment, the formulation proportion of the solid epoxy resin and the liquid phenolic resin is such that the hydroxyl group in the liquid phenolic resin is adjusted to preferably 0.7 to 1.4 eq., more preferably 0.9 to 1.1 eq., per one eq. of the epoxy group in the solid epoxy resin.

In the Second Embodiment, in the above-mentioned combination of the solid epoxy resin with the liquid phenolic resin, it is preferable to use, for instance, the combination of the tetrafunctional naphthalenic epoxy resin with the allylated phenol novolak resin, from the viewpoints of heat resistance and fluidity.

Finally, the Third Embodiment, which is a resin composition comprising a solid epoxy resin as the epoxy resin (the component A) and a solid phenolic resin as the phenolic resin (the component B), will be described.

As the above-mentioned solid epoxy resin, the same ones as those of the solid epoxy resins described in the Second Embodiment can be used.

In addition, among the solid epoxy resins, when the crystalline epoxy resin is used, it is preferable to use two or more kinds of the solid epoxy resins in admixture, because the fluidity is impaired at a temperature of 80°C or less when a crystalline epoxy resin having a melting point of 90°C or more is used.

The crystalline epoxy resin described above includes, for instance, one commercially available under the trade name of GK-4137 (manufactured by Nippon Steel Chemical Co., Ltd.), the trade name of GK-5079 (manufactured by Nippon Steel Chemical Co., Ltd.), the trade name of YDC-1312 (manufactured by Toto Kasei), and the like. The above-mentioned GK-4137 is represented by the following formula:

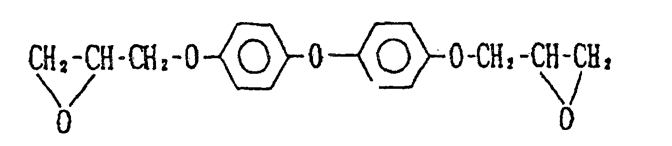

Also, the above-mentioned GK-5079 is represented by the following formula:

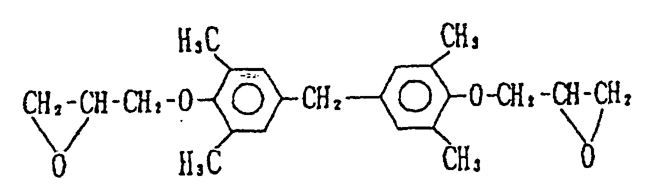

Further, the above-mentioned YDC-1312 is represented by the following formula:

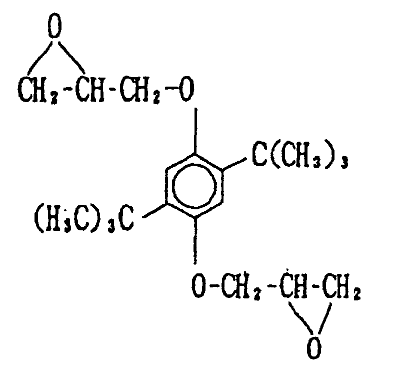

In addition, among the above-mentioned crystalline epoxy resins, the biphenyl epoxy resin is represented by the following formula:

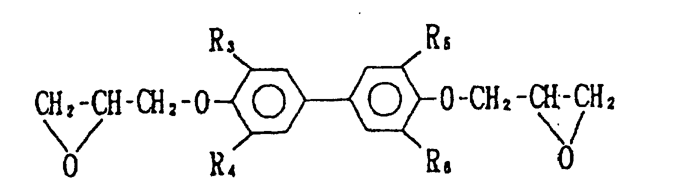

In the above-mentioned general formula, each of R₃ to R₆, which may be identical or different, is hydrogen atom, a linear or branched lower alkyl group such as methyl group, ethyl group, n-propyl group, isopropyl group, n-butyl group, isobutyl group, sec-butyl group, or tert-butyl group.

Also, there may be used as the above-mentioned biphenyl epoxy resin, a mixture of a biphenyl epoxy resin in which all of the above-mentioned R₃ to R₆ are methyl groups with a biphenyl epoxy resin in which all of the above-mentioned R₃ to R₆ are hydrogen atoms in approximately the same amount.

As the solid phenolic resin which is used together with the above-mentioned solid epoxy resin, the same ones as those of the solid phenolic resins described in the First Embodiment can be used.

Also, in the Third Embodiment, the formulation proportion of the solid epoxy resin and the solid phenolic resin is such that the hydroxyl group in the solid phenolic resin is adjusted to preferably 0.6 to 1.4 eq., more preferably 0.7 to 1.1 eq., per one eq. of the epoxy group in the solid epoxy resin.

In the Third Embodiment, in the combination of the solid epoxy resin with the solid phenolic resin, it is preferable to use, for instance, the combination of the crystalline epoxy resin such as one commercially available under the trade name of GK-4137 (manufactured by Nippon Steel Chemical Co., Ltd.) with the polyfunctional solid phenolic resin; or the combination of the tetrafunctional naphthalenic epoxy resin or triphenylmethane epoxy resin with the bifunctional bisphenol resin, from the viewpoints of thermosetting property, heat resistance and fluidity.

Also, in the resin composition of the present invention, a latent curing accelerator (the component C) is contained as an essential component together with each epoxy resin and each phenolic resin in the First to Third Embodiments mentioned above.

The above-mentioned term "latent curing accelerator" (the component C) refers to a curing accelerator which is stable for a long period of time as long as the resin composition containing an epoxy resin and a phenolic resin is allowed to stand at room temperature, but is unstable by applying heat, whereby a curing reaction is immediately accelerated. Concretely, the latent curing accelerator refers to those having a property such that a resin composition comprising the latent curing accelerator has a viscosity at 80°C after treatment of 10 times or less than the viscosity before treatment, wherein the treatment comprises allowing the resin composition to stand in an atmosphere of 50°C for 72 hours The latent curing accelerator is a microcapsulated curing accelerator having a core/shell structure comprising a core portion made of various curing agents and a shell portion having urea bonding, wherein the core portion is covered with the shell portion. It is preferable to use a microcapsulated curing accelerator in which a reactive amino group existing in the shell portion is blocked.

Since the microcapsulated curing accelerator is contained in the resin composition of the present invention, the resin composition has very long operable time and is especially excellent in the storage stability. The ordinary curing accelerator can be used together with the latent curing agent (the component C) in the present invention, so long as the viscosity of the resin composition after the treatment is kept at 10 times or less, usually 1 to 3 times, that before the treatment when the ordinary curing accelerator is formulated in a small amount.

In the above-mentioned microcapsulated curing accelerator, the curing accelerator incorporated as the core portion is not particularly limited, as long as it has an action of accelerating the curing reaction, and any known curing accelerators can be used. In such cases, it is preferable that the curing accelerator is liquid at room temperature, from the viewpoints of the workability during the preparation of the microcapsule and the properties of the microcapsule. In the present invention, the phrase "liquid at room temperature" not only refers to those which are liquid at room temperature (25°C) but also encompasses those which are solid at room temperature but can be prepared into the form of a solution or dispersion by dissolving or dispersing a solid curing accelerator with an optional organic solvent or the like.

The microcapsule-incorporated curing accelerator described above includes, for instance, amine-based curing accelerators, imidazole-based curing accelerators, phosphorus-containing curing accelerators, boron-containing curing accelerators, and phosphorus-boron-based curing accelerators. Concrete examples of the microcapsule-incorporated curing accelerator include alkyl- or aryl-substituted guanidines such as ethyl guanidine, trimethyl guanidine, phenyl guanidine, and diphenyl guanidine; 3-substituted phenyl-1,1-dimethylureas such as 3-(3,4-dichlorophenyl)-1,1-dimethylurea, 3-phenyl-1,1-dimethylurea, and 3-(4-chlorophenyl)-1,1-dimethylurea; imidazolines such as 2-methylimidazoline, 2-phenylimidazoline, 2-undecylimidazoline, and 2-heptadecylimidazoline; monoaminopyridines such as 2-aminopyridine; amine-imides such as N,N-dimethyl-N-(2-hydroxy-3-allyloxypropyl)amine-N'-lactimide; organophosphorus compounds such as ethylphosphine, propylphosphine, butylphosphine, phenylphosphine, trimethylphosphine, triethylphosphine, tributylphosphine, trioctylphosphine, triphenylphosphine, tricyclohexylphosphine, triphenylphosphine/triphenylborane complexes, and tetraphenylphosphonium tetraphenylborate; diazabicycloalkene compounds such as 1,8-diazabicyclo[5.4.0]undecene-7,1,4-diazabicyclo[2.2.2]octane; and the like. The microcapsule-incorporated curing accelerators can be used alone or in admixture or two or more kinds. Especially, the imidazole compounds and the organophosphorus compounds are preferable, from the viewpoints of the easiness of the preparation of the curing accelerator-incorporated microcapsule and easiness in handling.

The polymer constituting the above-mentioned shell portion, as long as the polymer has the urea bond as a structural unit can be obtained, for instance, by poly-addition reaction of a polyisocyanate with a polyamine. Also, the polymer can be obtained by the reaction of the polyisocyanate with water.

The above-mentioned polyisocyanate may be any compound, as long as it has two or more isocyanate groups in its molecule. Concrete examples of the polyisocyanate include diisocyanates such as *m*-phenylene diisocyanate, *p*-phenylene diisocyanate, 2,4-tolylene diisocyanate, 2,6-tolylene diisocyanate, naphthalene-1,4-diisocyanate, diphenylmethane-4,4'-diisocyanate, 3,3'-dimethoxy-4,4'-biphenyl diisocyanate, 3,3'-dimethyldiphenylmethane-4,4'-diisocyanate, xylylene-1,4-diisocyanate, 4,4'-diphenylpropane diisocyanate, trimethylene diisocyanate, hexamethylene diisocyanate, propylene-1,2-diisocyanate, butylene-1,2-diisocyanate, cyclohexylene-1,2-diisocyanate, and cyclohexylene-1,4-diisocyanate; triisocyanates such as p-phenylene diisothiocyanate, xylylene-1,4-diisothiocyanate, and ethylidyne diisothiocyanate; tetraisocyanates such as 4,4'-dimethyldiphenylmethane-2,2',5,5'-tetraisocyanate; isocyanate prepolymers such as an adduct of hexamethylene diisocyanate and hexanetriol, an adduct of 2,4-tolylene diisocyanate and Brenzcatechol, an adduct of tolylene diisocyanate and hexanetriol, an adduct of tolylene diisocyanate and trimethylolpropane, an adduct of xylylene diisocyanate and trimethylolpropane, an adduct of hexamethylene diisocyanate and trimethylolpropane, and trimers of aliphatic polyisocyanates, such as triphenyldimethylene triisocyanate, tetraphenyltrimethylene tetraisocyanate, pentaphenyltetramethylene pentaisocyanate, lysine isocyanate, and hexamethylene diisocyanate, and the like. These polyisocyanates can be used alone or in admixture of two or more kinds.

Among these polyisocyanates, the isocyanate prepolymers represented by the adduct of tolylene diisocyanate and trimethylolpropane, the adduct of xylylene diisocyanate and trimethylolpropane, and the polymethylenepolyphenyl isocyanates, such as triphenyldimethylene triisocyanate are especially preferable, from the viewpoints of the film-forming property during the preparation of the microcapsule and the mechanical strength.

On the other hand, the polyamines to be reacted with the above-mentioned polyisocyanate may be any compound, as long as it has two or more amino groups in its molecule. Concrete examples of the polyamines include diethylenetriamine, triethylenetetramine, tetraethylenepentamine, 1,6-hexamethylenediamine, 1,8-octamethylenediamine, 1,12-dodecamethylenediamine, *o*-phenylenediamine, *m*-phenylenediamine, *p*-phenylenediamine, *o*-xylylenediamine, *m*-xylylenediamine, *p*-xylylenediamine, menthanediamine, bis(4-amino-3-methylcyclohexyl)methane, isophoronediamine, 1,3-diaminocyclohexane, spiro-acetal-based diamines, and the like. These polyamines can be used alone or in admixture of two or more kinds.

In addition, in the reaction of the above-mentioned polyisocyanate with water, first, an amine is formed by hydrolysis of a polyisocyanate, and the resulting amine is reacted with unreacted isocyanate group (so-called "self poly-addition reaction"), thereby forming a polymer comprising a polymer having a urea bond as a structural unit as a main component.

Further, as the polymer capable of forming a shell portion (wall film) of the microcapsulated curing agent, there can be also used a polyurethane-polyurea prepared from a polyhydric alcohol together with the above-mentioned polyisocyanate to incorporate a urea bond in the structural unit.

The polyhydric alcohol which is used in the formation of polyurethane-polyurea may be aliphatic, aromatic or alicyclic. The polyhydric alcohol includes catechol, resorcinol, 1,2-dihydroxy-4-methylbenzene, 1,3-dihydroxy-5-methylbenzene, 3,4-dihydroxy-1-methylbenzene, 3,5-dihydroxy-1-methylbenzene, 2,4-dihydroxyethylbenzene, 1,3-naphthalenediol, 1,5-naphthalenediol, 2,7-naphthalenediol, 2,3-naphthalenediol, *o,o'* -biphenol,*p,p '*-biphenol, bisphenol A, bis(2-hydroxyphenyl)methane, xylylene diol, ethylene glycol, 1,3-propylene glycol, 1,4-butylene glycol, 1,5-pentanediol, 1,6-hexanediol, 1,7-heptanediol, 1,8-octanediol, 1,1,1-trimethylolpropane, hexanetriol, pentaerythritol, glycerol, sorbitol, and the like. These polyhydric alcohols can be used alone or in admixture of two or more kinds.

The above-mentioned microcapsulated curing accelerator can be prepared by a known process for preparing a microcapsule. For instance, the microcapsulated curing accelerator can be prepared by following the three-step process described below.

### [First Step]

A core component curing accelerator is dissolved or finely dispersed in a polyisocyanate, which is a raw material for wall film (shell) to form an oil phase. Next, an O/W type (oil phase/water phase type) emulsion is prepared by dispersing the above-mentioned oil phase in a oil droplet form in an aqueous medium (water phase) containing a dispersion stabilizer. Subsequently, a polyamine is added to the water phase of the above-mentioned O/W type emulsion to be dissolved, thereby carrying out poly-addition reaction by the interfacial polymerization of the polyamine with the polyisocyanate in the oil phase. Alternatively, the above-mentioned O/W type emulsion is heated, so that the polyisocyanate in the oil phase is reacted with water at the interface with the water phase to form an amine, and subsequently the resulting amine is subjected to a self poly-addition reaction. As described above, a microcapsule comprising a polyurea polymer having urea bonds in its molecule as a shell portion is formed, and a liquid dispersing the microcapsulated curing accelerator is obtained.

On the other hand, when the core component is prepared by dissolving a solid curing accelerator in an organic solvent, an S/O/W (solid phase/oil phase/water phase) emulsion is prepared. In addition, this emulsion type is a case where the curing accelerator is lipophilic. In a case where the curing accelerator is hydrophilic, the above-mentioned emulsion type is less likely to be prepared. In such a case, an O/O (oil phase/oil phase) emulsion type or an S/O/O (solid phase/oil phase/oil phase) emulsion type can be prepared by adjusting its solubility, and the interfacial polymerization may be carried out therewith.

The organic solvent in this case is not particularly limited, as long as the organic solvent is liquid at room temperature, provided that at least an organic solvent which does not dissolve the shell portion must be selected. Concretely, organic solvents such as ethyl acetate, methyl ethyl ketone, acetone, methylene chloride, xylene, toluene and tetrahydrofuran; and oils such as phenylxylylethane and dialkylnaphthalenes can be used.

### [Second Step]

A blocking agent is added to the dispersion of microcapsules obtained in the first step, to dissolve or disperse the blocking agent in the dispersion. During this step, it is effective to add the above-mentioned blocking agent after once removing the dispersion stabilizer and the unreacted amine in the water phase of the dispersion of microcapsules by such means as centrifugation.

### [Third Step]

The dispersion of the microcapsules of which amino groups are blocked with the blocking agent in the second step is subjected to such a treatment as centrifugation or filtration to remove an excess blocking agent, and thereafter dried, thereby giving powdery microcapsulated curing agent.

In the above-mentioned first step, the dispersion stabilizer to be added to the aqueous medium (water phase) includes water-soluble polymers such as polyvinyl alcohols and hydroxymethyl cellulose; surfactants such as anionic surfactants, nonionic surfactants and cationic surfactants; and the like. In addition, hydrophilic inorganic colloidal substances such as colloidal silica and mineral clays; and the like can be also used. It is preferable that the amount of these dispersion stabilizers is adjusted to 0.1 to 10% by weight in the water phase.

The blocking agent to be used in the above-mentioned second step is not particularly limited, as long as the blocking agent is a compound which is reactive with amino group. The blocking agent includes, for instance, compounds capable of forming a covalent bond by the reaction with amino group, such as epoxy compounds, aldehyde compounds, acid anhydrides, ester compounds, and isocyanate compounds. The blocking agent may further include acidic compounds capable of forming a salt by neutral reaction with amino group, such as organic carboxylic acids such as acetic acid, formic acid, lactic acid, oxalic acid, and succinic acid; organic sulfonic acids such as p-toluenesulfonic acid, 2-naphthalenesulfonic acid, and dodecylbenzenesulfonic acid; phenolic compounds; inorganic acids such as boric acid, phosphoric acid, nitric acid, nitrous acid, and hydrochloric acid; solid substances having acidic surfaces such as silica and Aerozil; and the like. Among these compounds, the acidic compounds are preferably used as a compound effectively blocking amino group existing on the wall film surface and in the internal wall film, and formic acid and organic sulfonic acids are especially preferably used.

The above-mentioned blocking agent is added in an amount of a molar equivalence to the amino groups existing on the wall film surface and in the internal wall film. Practically speaking, in a case, for instance, where the acidic compound is used as a blocking agent, the blocking agent can be added by a method comprising adding the acidic substance (acidic compound) to a dispersion immediately after the preparation of the microcapsules (immediately after interfacial polymerization); adjusting the pH of the dispersion from basic to acidic, preferably to a pH of 2 to 5; and thereafter removing an excess acidic compound by such means as centrifugation or filtration.

In addition, in the process for preparing the microcapsulated curing accelerator comprising the first to third steps described above, as a second step, a technique of removing unreacted free amines or neutralizing residual amino groups by applying the dispersion of microcapsules on an acidic cationic exchange resin column can be employed.

The average particle size of the resulting microcapsulated curing accelerator is not particularly limited. For instance, it is preferable that the average particle size is adjusted to a range of from 0.05 to 500 µm, more preferably from 0.1 to 30 µm, from the viewpoint of homogeneous dispersibility. The shape of the above-mentioned microcapsulated curing accelerator is preferably spherical, from the viewpoint of dispersibility, but the shape may be elliptic. In the case where the shape of the microcapsules is not spherical and one of which particle size is not evenly determined as in the case of elliptic or oblate, a simple average value of its longest diameter and shortest diameter is defined as an average particle size.

Further, in the above-mentioned microcapsulated curing accelerator, the amount of the curing accelerator incorporated is preferably adjusted to 10 to 95% by weight of the entire amount of the microcapsule, especially preferably adjusted to 30 to 80% by weight. Specifically, when the amount of the curing accelerator incorporated is less than 10% by weight, the time period for the curing reaction is too long, showing impaired reactivity. On the other hand, when the amount of the curing accelerator incorporated exceeds 95% by weight, the thickness of the wall film becomes too thin, thereby risking impaired isolation of the core portion (curing agent) and impaired mechanical strength.

In addition, the ratio of the thickness of the shell portion to the particle size of the above-mentioned microcapsulated curing accelerator is preferably adjusted to 3 to 25%, especially preferably adjusted to 5 to 25%. When the above-mentioned ratio is less than 3%, a sufficient mechanical strength cannot be obtained for the shearing strength applied during the kneading process during the preparation of the resin composition. When the ratio exceeds 25%, the release of the incorporated curing agent tends to be insufficient.

In each of the above-mentioned Embodiments, the formulation amount of the above-mentioned latent curing accelerator (the component C) is adjusted to 0.1 to 40 parts by weight, based on 100 parts by weight of the phenolic resin (the component B), especially preferably 5 to 20 parts by weight. When the formulation amount of the latent curing accelerator is less than 0.1 parts by weight, the curing rate is too slow, thereby causing the lowering of the strength. When the formulation amount exceeds 40 parts by weight, the curing rate is too fast, thereby risking impaired fluidity.

In the present invention, as the latent curing accelerator, the component C, commercially available microcapsulated curing accelerators can be used besides those curing accelerator-incorporated microcapsules mentioned above, as long as a desired object is not hindered. The commercially available products, for instance, include one commercially available under the trade name of MCE-9957 (manufactured by NIPPON KAYAKU CO., LTD.; one in which methyl methacrylate is used as a wall film), Novacure manufactured by Asahi-Ciba (trade names HX-3748, HX-3741, HX-3742, HX-3921HR, and HX-3941HP), and the like. In addition, those curing accelerators besides the microcapsulated curing accelerators mentioned above may be used as latent curing accelerators, including those which have weak catalytic activities such as dicyandiamide, and FUJICURE FXR-1030 and FXE-1000 manufactured by Fuji Kasei Kogyo; and those of which catalytic activities are weakened by adding a small amount of an ordinary curing accelerator.

The resin composition of the present invention is heated to a given temperature or higher, and the curing accelerator in the microcapsule is released to the outside of the shell to cure the epoxy resin, to give a desired cured product. The heat-releasing phenomenon described above in the curing method is due to a physical change of the microcapsule, not dominant by a diffusion-transmittance through the shell of the microcapsule as disclosed in Japanese Patent Laid-Open No. Hei 1-242616. In other words, the incorporated curing accelerator is released due to the change in the shape of the microcapsule and the dissolution to the epoxy resin of the shell component of the microcapsule. There are two embodiments in the dissolution of the shell: Complete dissolution and partial dissolution.

In the curing method described above, the above-mentioned phenomenon of heating and dissolution (breaking) of the microcapsule surprisingly takes place at such a very low temperature of 80° to 150°C and instantly, even when the shell component comprises a relatively rigid cross-linked structure. Therefore, even when the thickness of the shell is thickened, the thermosetting property (releasability of the core from the microcapsule) is not lowered. Such a dissolution phenomenon does not takes place by heating to a temperature of about 90° to about 200°C without formulating the microcapsulated curing accelerator alone as in the curing method described above, nor does it take place even when heated in a liquid medium such as an oil. In other words, the polymer having a specified structure constituting the shell of the microcapsulated curing accelerator is allowed to cause the above-mentioned curing reaction when formulated with the resin composition.

Although the action mechanism in the curing method described above is not clarified, it is presumably as follows. The structure unit of the shell having a specified structure undergoes a dissociation reaction under a relatively low temperature when being coexistent with the epoxy resin. In addition, the temperature at which the dissociation reaction takes place can be adjusted by the structure (composition) of the polymer constituting the shell and the kinds of the epoxy resin being coexistent therewith. The structure of the polymer constituting the shell can be varied by the kinds of the polyisocyanate and the polyamine used in the formation of the shell by interfacial polymerization, or by the use of two or more kinds of the polyisocyanates. The breaking temperature of the shell in the microcapsule as referred to herein is determined by a initial rise temperature of the exothermic peak as determined by DSC determination.

In the resin composition of the present invention, there can be optionally added various auxiliary agents such as an inorganic filler, a flame retarder, a leveling agent, a defoaming agent, a pigment, a dye, a silane coupling agent, a titanate coupling agent, and a flux agent in proper amounts, together with the above-mentioned components A to C.

The inorganic filler is not particularly limited, and various inorganic fillers can be used. Concrete examples of the inorganic filler include silica, clay, gypsum, calcium carbonate, barium sulfate, aluminum oxide, beryllium oxide, silicon carbide, silicon nitride, Aerozil, and the like. In order to give conductivity or semi-conductivity, conductive particles made of nickel, gold, copper, silver, tin, lead, bismuth or the like may be added. Among them, it is preferable to use spherical silica powder, especially preferably spherical molten silica powder. Further, those spherical silica powders having an average particle size in the range of 0.01 to 60 µm are preferable, more preferably in the range of 0.1 to 15 µm. In the present invention, the term "spherical" refers to those have a sphericity of 0.85 or more in average, as determined by using a flow-type particle image analyzer (Model "FPIA-100," manufactured by SYSMEX).

It is preferable that the content proportion of the above-mentioned inorganic filler is adjusted to 15 to 85% by weight of an entire resin composition, especially preferably adjusted to 50 to 80% by weight. Specifically, when the content proportion of the inorganic filler is less than 15% by weight, the viscosity becomes too low at 25°C, so that the sedimentation of the inorganic filler is caused during storage, and at the same time the hygroscopic ratio becomes high, so that the moisture tolerance reliability tends to be impaired. In addition, when the content proportion of the inorganic filler exceeds 85% by weight, the fluidity is lowered, so that the dischargeability and the coating workability tend to be impaired.

The above-mentioned silane coupling agent includes, for instance, γ-mercaptopropyl trimethoxysilane, γ-glycidoxypropyl methyldiethoxysilane, β-(3,4-epoxycyclohexyl)ethyl trimethoxysilane, γ-methacryloxypropyl trimethoxysilane, amino group-containing silanes, and the like. These silane coupling agents can be used alone or in admixture of two or more kinds.

The above-mentioned flame retarder includes novolak brominated epoxy resins; brominated bisphenol A epoxy resins; metal compounds such as antimony trioxide, antimony pentoxide, magnesium hydroxide, and aluminum hydroxide; phosphorus-containing compounds such as red phosphorus, and phosphates. These flame retarders can be used alone or in admixture of two or more kinds.

The above-mentioned wax includes compounds such as higher fatty acids, higher fatty acid esters, calcium salts of higher fatty acids, and amides. These waxes can be used alone or in admixture of two or more kinds.

Further, in the resin composition of the present invention, besides the other auxiliary agents mentioned above, components such as silicone oils, silicone rubbers, synthetic rubbers, and reactive diluents can be formulated in order to achieve low compression, and ion capturing agents such as hydrotalcites and bismuth hydroxide can be properly formulated for the purpose of improving the reliability in the moisture tolerance resistance test.

The resin composition of the present invention can be, for instance, prepared as follows. Specifically, the components A to C mentioned above and optionally other auxiliary agents are mixed with each other, and the mixture is blended in a molten state by kneading with a kneader such as a universal stirring reactor with heating. Thereafter, the molten mixture is cooled to room temperature (about 25°C or so), to give a desired resin composition of the present invention. Here, in order to adjust the fluidity of the resulting resin composition, one or more organic solvents selected from toluene, xylene, methyl ethyl ketone, acetone, and diacetone alcohol can be added to the resin composition.

It is essential that the resin composition prepared as described above is a solid at 25°C, or has a viscosity of not less than 400 Pa•s at 25°C and a viscosity of not more than 200 Pa•s at 80°C, preferably a viscosity of not less than 700 Pa•s at 25°C and a viscosity within the range of 0.1 to 5 Pa•s at 80°C. Specifically, when the viscosity is less than 400 Pa•s at 25°C or exceeds 200 Pa•s at 80°C, the storage stability and the dischargeability and coating workability are impaired, so that desired properties cannot be satisfied.

In the present invention, each of the viscosities at 25°C and at 80°C of the resin composition is determined by using an E-type viscometer. Concrete determination methods are as follows.

### [Viscosity at 25°C]

The viscosity is determined after pre-treating a resin composition with a cone-shaped rotor at a rotational speed of 1 rpm for 1 minute, and thereafter allowing the resin composition to stand at 0.1 rpm for 10 minutes, using a rotor 3°× R7.7 under the model name of "RE80U" manufactured by Toki Sangyo.

### [Viscosity at 80°C]

The viscosity is determined after pre-treating a resin composition with a cone-shaped rotor at a rotational speed of 1 rpm for 1 minute, and thereafter allowing the resin composition to stand at 0.5 rpm for 10 minutes, using a rotor under the model name of "RE80R" manufactured by Toki Sangyo, provided that those having a viscosity of less than 100 Pa•s are determined by 3°× R14, and that those having a viscosity 100 Pa•s or more are determined by 3°× R7.7.

The production of the semiconductor device using the resin composition of the present invention can be carried out by various known methods. For instance, in the mounting such as flip chip, COB, graft chip, or cavity fill, the above-mentioned resin composition heated to about 40° to about 90°C, preferably to about 60° to about 80°C, is subjected to potting with a dispenser, and thereafter the resin composition is heated and cured to form a sealing resin layer, whereby a semiconductor device can be produced. Alternatively, a solid or semi-solid resin composition is directly pasted or coated on a semiconductor element without previously heating the resin composition, and thereafter the resin composition is heated and cured to form a sealing resin layer, whereby a semiconductor device can be produced. The above-mentioned mounting may be carried out under vacuum.

Among the above-mentioned methods for producing the semiconductor devices, concrete explanations for flip-chip mounting will be given below, using side-fill sealing method, press-bump sealing method, and printing sealing method as exemplifications.

### [Side-Fill Sealing Method]

First, a wiring circuit substrate and semiconductor elements mounted thereon via plural connecting electrodes are provided. Thereafter, the above-mentioned resin composition heated to about 40° to about 90°C, preferably to about 60° to about 80°C, is poured with a dispenser to fill a gap between the wiring circuit substrate and the semiconductor elements previously heated to about 40° to about 130°C, preferably to about 60° to about 100°C, and thereafter the resin composition is heated and cured to form a sealing resin layer, whereby the semiconductor device can be produced by flip-chip mounting.

Incidentally, the solid or semi-solid resin composition can be directly pasted on or near the semiconductor element or coated on the semiconductor element without previously heating the resin composition, and thereafter the resin composition is heated and cured to form a sealing resin layer in the gap between the above-mentioned semiconductor element and the wiring circuit substrate.

In addition, the semiconductor device may be produced by the above-mentioned side-fill sealing method under vacuum. The devices for producing the semiconductor device under vacuum include, for instance, ones manufactured by Musashi Engineering under the model numbers of MBC-V series. Further, when the semiconductor device is produced under vacuum as described above, a so-called "differential pressure filling" can be carried out, wherein after the resin composition is poured with a dispenser to fill a gap between the wiring circuit substrate and the semiconductor element under vacuum, the resin composition is further filled after the pressure is changed back to atmospheric pressure.

### [Press-Bump Sealing Method]

First, the above-mentioned resin composition heated to about 40° to about 90°C, preferably to about 60° to about 80°C, is subjected to potting with a dispenser on a wiring circuit substrate. Thereafter, a sealing resin layer is formed, and at the same time the electric connection is provided between the semiconductor element and the wiring circuit substrate by a press-bump connecting means by a flip-chip bonder, whereby the semiconductor device can be produced by flip-chip mounting.

Incidentally, the solid or semi-solid resin composition can be directly pasted or coated on the semiconductor element or the wiring circuit substrate, and thereafter the resin composition is heated and cured to form a sealing resin layer, and at the same time to connect the above-mentioned semiconductor element with the wiring circuit substrate by the press-bump connecting means.

The semiconductor device may be produced by the above-mentioned press-bump sealing method under vacuum as occasion demands.

In addition, instead of potting with a dispenser, the resin composition may be coated by printing, and thereafter a sealing resin layer may be formed, and at the same time the electric connection may be provided between the semiconductor element and the wiring circuit substrate by means of a press-bump connection by a flip-chip bonder. In this case, the coating by printing may be carried out with heating an entire printing atmosphere, or partially heating by masking or squeezing a part of the atmosphere (heating temperature measure being 40° to 100°C).

### [Printing Sealing Method]

First, a wiring circuit substrate and semiconductor elements mounted thereon via plural connecting electrodes are provided. Thereafter, the above-mentioned resin composition heated to about 40° to about 90°C, preferably to about 60° to about 80°C, is added dropwise with a dispenser to a gap between the wiring circuit substrate and the semiconductor elements previously heated to about 40° to about 130°C, preferably to about 60° to about 100°C, and thereafter subjected to printing sealing, whereby the semiconductor device can be produced by flip-chip mounting.

As to the above-mentioned printing sealing, it is preferable to use vacuum printing sealing devices (model no. VPE-100 series) manufactured by Toray Engineering utilizing vacuum differential pressure, from the viewpoint of avoiding the entry of the bubbles into the sealing resin layer.

Incidentally, the printing sealing can be also carried out by directly pasting or coating a solid or semi-solid resin composition to a stage, a squeeze or the like.

Next, among the above-mentioned methods for producing a semiconductor device, a method for producing a semiconductor device in the cavity-fill form will be concretely described.

First, a wiring circuit substrate and semiconductor elements mounted thereon are provided, wherein the wiring circuit substrate and the semiconductor elements are electrically connected with a bonding wire or the like. Thereafter, the above-mentioned resin composition heated to about 40° to about 90°C, preferably to about 60° to about 80°C, is subjected to potting to the wiring circuit substrate and the semiconductor elements previously heated to about 40° to about 130°C, preferably to about 60° to about 100°C with a dispenser, and thereafter the resin composition is heated and cured to form an encapsulation resin layer so as to incorporate the semiconductor elements in the encapsulation resin layer, whereby the semiconductor device in the cavity-fill form can be produced.

Incidentally, the solid or semi-solid resin composition can be directly pasted or coated on the semiconductor element or the wiring circuit substrate without previously heating the resin composition, and thereafter the resin composition is heated and cured to form an encapsulation resin layer so as to incorporate the semiconductor elements in the encapsulation resin layer.

In addition, the semiconductor device may be produced by the above-mentioned printing sealing method under vacuum. The devices for producing the semiconductor device under vacuum include, for instance, ones manufactured by Musashi Engineering under the model numbers of MBC-V series.

Other methods for producing a semiconductor device in the cavity-fill form will be described. Specifically, first, a wiring circuit substrate and semiconductor elements mounted thereon are provided, wherein the wiring circuit substrate and the semiconductor elements are electrically connected with a bonding wire or the like. Thereafter, the above-mentioned resin composition heated to about 40° to about 90°C, preferably to about 60° to about 80°C, is fed by printing to the wiring circuit substrate and the semiconductor elements previously heated to about 40° to about 130°C, preferably to about 60° to about 100°C with a dispenser, and thereafter the resin composition is heated and cured to form an encapsulation resin layer so as to incorporate the semiconductor elements in the encapsulation resin layer, whereby the semiconductor device in the cavity-fill form can be produced.

In addition, the semiconductor device may be produced by the above-mentioned printing sealing under vacuum. Further, when the semiconductor device is produced under vacuum, after the resin composition is subjected to printing sealing under vacuum, the pressure of the atmosphere is increased to degas voids in the resin composition, and the resin composition may be subjected to a further finish printing in this state.

The method of heating and curing the above-mentioned resin composition is not particularly limited. The method includes, for instance, heating methods utilizing countercurrent dryers, IR reflow furnaces, hot plates, and the like.

The method of filling a gap between the external substrate and the semiconductor device by the use of the resin composition of the present invention includes, for instance, side-fill sealing method, press-bump sealing method, printing sealing method, and the like, which are similar to those described for the flip-chip mounting in the method for producing a semiconductor device described above. Incidentally, conductive particles made of nickel, gold, silver, copper, tin, lead, bismuth or the like may be dispersed in the above-mentioned resin composition to give ACF (anisotropic conductive film) or ACP (anisotropic conductive paste) to be used for flip chip mounting. Other methods of use of the resin composition include the use of the resin composition formed on the wiring circuit substrate as a material for dam, or a bonding agent between the wiring circuit substrate and a radiator plate, and a die-bonding agent.

The semiconductor device using the resin composition of the present invention to a conductive wafer or a matrix-like wire circuit substrate can be produced by various known methods.

An embodiment where plural projected electrode-mounted semiconductor elements are formed on a semiconductor wafer will be described. Specifically, the above-mentioned resin composition heated to 40° to about 90°C, preferably to about 60° to about 80°C, is coated on the above-mentioned projected electrode-mounted surface with a dispenser to form a resin layer made of the above-mentioned resin composition having a given thickness. When the resin layer made of the above-mentioned resin composition having a given thickness is formed, it is so arranged that at least the tip ends of the above-mentioned projected electrodes are exposed from the above-mentioned resin layer. Next, the resulting semiconductor wafer in which the above-mentioned resin layer is formed is cut, to prepare a semiconductor device.

The method for forming a resin layer made of the above-mentioned resin composition includes a method of forming the resin layer by printing through an aperture of the mask.

The resin layer thus formed may be heated and cured by the final stage, and the heating and curing step may be carried out before or after cutting the semiconductor wafer.

On the other hand, the above-mentioned resin composition is fed on the entire plural semiconductor elements mounted on the matrix-like wiring circuit substrate constituted by the individual wiring circuits, to form a resin layer so as to incorporate the semiconductor elements in the resin composition. Next, the resin composition is heat and cured to resin-encapsulate the plural semiconductor elements, and thereafter cut the resin-encapsulated, plural semiconductor elements into individual semiconductor devices, to give a semiconductor device.

The resin layer formed by the method described above may be heated and cured by the final stage, and the heating and curing step may be carried out before or after cutting into the individual semiconductor devices.

The method for forming a resin layer made of the above-mentioned resin composition includes a method using a dispenser, a method of forming the resin layer by printing through an aperture of the mask, and the like, which are the same as the those described above.

Also, in the semiconductor wafer having plural projected electrode-mounting semiconductor elements, the above-mentioned resin composition is fed to the above-mentioned projected electrode-mounting surface of the semiconductor wafer to form a resin layer having a given thickness, and thereafter the semiconductor wafer on which the above-mentioned resin layer is formed is cut into individual semiconductor elements. Next, the external substrate for mounting and the semiconductor element are heat-treated by heat-and-pressure fusing or soldering reflow in a state where the above-mentioned cut resin layer-formed side of the semiconductor element faces the external substrate, so that the external substrate and the semiconductor element are electrically connected, and at the same time the above-mentioned resin layer is heated and cured, thereby forming a sealing resin layer between the above-mentioned semiconductor element and the external substrate to be resin-sealed. As described above, the semiconductor device is prepared. Incidentally, heating and curing may be carried out before cutting the semiconductor wafer.

Further, the above-mentioned resin composition is fed to the matrix-like wiring circuit substrate comprising individual wiring circuits to form a resin layer, and thereafter the above-mentioned resin layer-formed wiring circuit substrate is cut into individual wiring circuit substrates. Next, the semiconductor elements and the wiring circuit substrate are heat-treated by heat-and-pressure fusing or soldering reflow, in a state where the above-mentioned cut wiring circuit substrate faces the connecting electrode-mounting side for connecting semiconductor elements each mounted with plural connecting electrodes, so that the cut wiring circuit substrate and the semiconductor device are electrically connected, and at the same time the above-mentioned resin layer is heat-treated, thereby forming a sealing resin layer between the semiconductor elements and the wiring circuit substrate to be resin-sealed. As described above, the semiconductor device is prepared.

The method for forming a resin layer made of the above-mentioned resin composition includes a method using a dispenser, a method of forming the resin layer by printing through an aperture of the mask, and the like, which are the same as the those described above.

### EXAMPLES

Next, the present invention will be described in further detail by means of the following Examples, and can be of course subject to various modifications and applications without departing from the gist of the present invention.

### [First Embodiment]

Examples and Comparative Examples of the First Embodiment will be described hereinbelow.

The component A (liquid epoxy resin), the component B (solid phenolic resin) and the component C (latent curing accelerator) used in Examples and Comparative Examples of the First Embodiment are as follows.

### [Component A, A1-1]:

A bisphenol F epoxy resin (liquid at 25°C, epoxy equivalence: 158 g/eq., manufactured by Toto Kasei, "Epitoto YDF-8170")

### [Component A, A1-2]:

A bisphenol A epoxy resin (liquid at 25°C, epoxy equivalence: 170 g/eq., manufactured by Dow Chemical, "DER-332")

### [Component B, B1-1]:

A tetrafunctional phenolic resin (solid at 25°C, melting point: 156°C, purity 93.6%), represented by the following formula:

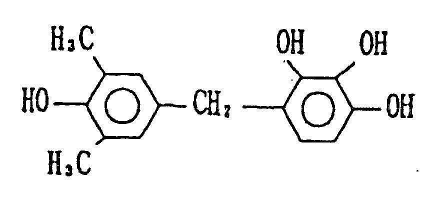

### [Component B, B1-2]:

A trifunctional phenolic resin (solid at 25°C, melting point: 94°C, purity 98%), represented by the following formula:

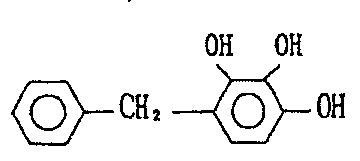

### [Component B, B1-3]:

Triphenylmethane phenolic resin (solid at 25°C, hydroxyl group equivalence: 101 g/eq., melting point: 110°C, viscosity: 0.3 to 0.4 Pa•s at 150°C, manufactured by Meiwa Kasei, MEH-7500 (3,4P))

### [Component B, B1-4] :

A mixture of a trifunctional phenolic resin and a tetrafunctional phenolic resin (ratio of each peak area to entire peak area: about 65 / about 30, as determined by liquid chromatography, solid at 25°C, melting point: 132°C, manufactured by Honshu Chemical Industry Co., Ltd., MHD-244LG)

### [Acid Anhydride-Based Curing Agent] (Optional Component):

Methylhexahydrophthalic acid anhydride

### [Component C, C1-1]:

A microcapsulated curing accelerator was prepared in accordance with the method described above. Specifically, first, 11 parts by weight of an adduct of 3 mol of xylylene diisocyanate and 1 mol of trimethylolpropane, and 4.6 parts by weight of an adduct of 3 mol of tolylene diisocyanate and 1 mol of trimethylolpropane were homogeneously dissolved in a mixed solution of 7 parts by weight of a curing accelerator triphenylphosphine, and 3.9 parts by weight of ethyl acetate to prepare an oil phase.

Next, an aqueous phase comprising 100 parts by weight of distilled water and 5 parts by weight of a polyvinyl alcohol was separately prepared. The oil phase prepared above was added to the aqueous phase, and the mixture was emulsified with a homomixer to give an emulsion state. A polymerization reactor equipped with a reflux tube, a stirrer and a dropping funnel was charged with the resulting emulsion.

On the other hand, 10 parts by weight of an aqueous solution containing 3 parts by weight of triethylenetetramine was prepared, and the dropping funnel provided with the above polymerization reactor was charged with this aqueous solution. The aqueous solution was added dropwise to the emulsion in the reactor to carry out interfacial polymerization at 70°C for 3 hours, to give an aqueous dispersion of a microcapsulated curing accelerator. Subsequently, the polyvinyl alcohol or the like in the aqueous phase was removed by centrifugation, and thereafter 100 parts by weight of distilled water was added thereto, to give a dispersion.

Formic acid was added to the resulting dispersion to adjust its pH to 3, thereby giving a microcapsulated curing accelerator in which amino groups of wall film surface and the inner portion were blocked with formic acid. The microcapsulated curing accelerator thus obtained was repeatedly separated by centrifugation and washed with water, and thereafter dried, to isolate as a powdery particle having free fluidity. The average particle size of the resulting microcapsulated curing accelerator was 2 µm. In addition, the ratio of the shell thickness to the particle size of the microcapsule was 15%, and the amount of triphenylphosphonine incorporated in the microcapsule was 30% by weight of the entire weight.

### [Component C, C1-2]:

Curing accelerator MCE-9957 manufactured by NIPPON KAYAKU CO., LTD.

### [Component C, C1-3]:

Curing accelerator 2-ethyl-4-methylimidazole

### Examples 1-1, 1-3 and 1-4

The epoxy resin and the phenolic resin were formulated in proportions as shown in Table 1, and the mixture was blended at 150°C for 2 minutes to dissolve the entire solid content. Next, the temperature was adjusted to 65°C. Thereafter, a latent curing accelerator was added thereto, and homogeneously mixed for 2 minutes.

### Examples 1-2, Comparative Example 1-1 and Conventional Example

The epoxy resin and the phenolic resin were formulated in proportions as shown in Table 1, and the mixture was blended at 110°C for 5 minutes to dissolve the entire solid content. Next, the temperature was adjusted to 65°C. Thereafter, a latent curing accelerator was added thereto, and homogeneously mixed for 2 minutes.

**Table 1**

| | Examples | | | | Comp. Example | Conventional Example |
|---|---|---|---|---|---|---|
| | 1-1 | 1-2 | 1-3 | 1-4* | 1-1 | |
| A1-1 | 158 | 158 | 158 | 158 | - | 158 |
| A1-2 | - | - | - | - | 175 | - |
| B1-1 | 65 | - | - | - | - | - |
| B1-2 | - | - | - | - | 80.7 | - |
| B1-3 | - | 101 | - | - | - | - |
| B 1-4 | - | - | 92 | 92 | - | - |
| C1-1 | 7.6 | 11.8 | 10.8 | - | - | - |
| C1-2 | - | - | - | 10.8 | - | - |
| C1-3 | - | - | - | - | 1.6 | 3.3 |
| Acid Anhydride Curing Agent | - | - | - | - | - | 168 |
| Viscosity, Pa•s | | | | | | |
| at 25°C | 510 | solid | 420 | 450 | 65 | 0.5 |
| at 80°C | 0.15 | 0.9 | 0.1 | 0.15 | 0.07 | 0.05 |
| Glass Transition Temperature (°C) | 138 | 141 | 125 | 128 | 125 | 125 |
| Storage Stability | ⓞ | ⓞ | ⓞ | ⓞ | × | × |
| Dischargeability and Coating Workability | ⓞ | ⓞ | ⓞ | ⓞ | × | × |
| Operable Time | ⓞ | ⓞ | ⓞ | ○ | × | × |

| | | | | | | |
|---|---|---|---|---|---|---|
| *Reference Example, not according to the invention | | | | | | |

With respect to each of the resulting resin compositions, each of the viscosities at 25°C and 80°C was determined in accordance with the method described above using an E-type viscometer. Further, the glass transition temperature (Tg), the storage stability (extent of change in viscosities), the dischargeability and coating workability, and the operable time were determined and evaluated in accordance with the following methods. The results are shown together in Table 1.

### [Glass Transition Temperature (Tg)]

A test piece obtained by curing a previously defoamed resin composition at 150°C for 3 hours was used to determine the glass transition temperature by using a TMA device (Model No. MG800GM) manufactured by Rigaku. The determination was carried out at a heating rate of 5°C/min with a load of 30 g. Thereafter, a graph plotting temperature as abscissa and elongation as ordinate was prepared. An intersection point of a tangent line between 50° and 70°C and a tangent line between 200° and 230°C was defined as Tg.

### [Storage Stability (Extent of Change in Viscosities)]

The resin composition was treated by allowing the resin composition to stand in an atmosphere at 25°C for 30 days. The viscosities before and after the treatment were determined by using the E-type viscometer (determination temperature: 80°C for examples and comparative examples, 25°C for conventional example). The evaluation criteria are as follows.
ⓞ: the viscosity after the treatment being 1.5 times or less that of the viscosity before the treatment;
○: the viscosity after the treatment 3.0 times or less and exceeding 1.5 times that of the viscosity before the treatment;
Δ: the viscosity after the treatment 10 times or less and exceeding 3.0 times that of the viscosity before the treatment; and
× : the viscosity after the treatment exceeding 10 times that of the viscosity before the treatment.

Also, the determination of the viscosity using the E-type viscometer was carried out in the same manner as the method for determining the viscosities at 25°C and 80°C mentioned above.

### [Dischargeability and Coating Workability]

The dischargeability was evaluated by the amount of discharge when the resin composition heated to 80°C was discharged under given time and pressure conditions using a dispenser. Specifically, the amount of discharge was determined by using a 10 cc syringe and a metallic needle SN-17G (inner diameter 2.4 mm) manufactured by Musashi Engineering at a pressure of 5 kg/cm² for 10 seconds. The evaluation criteria are as follows.
ⓞ: the amount of discharge being 1000 mg or more;
○: the amount of discharge being 200 mg or more and less than 1000 mg;
Δ: the amount of discharge being 50 mg or more and less than 200 mg; and
× : the amount of discharge being less than 50 mg.

When the amount of discharge is less than 50 mg, the resin encapsulation of the semiconductor device is at a level in which encapsulation cannot be made.

### [Operable Time (Change in Viscosities)]

Each of the resin compositions was treated by allowing the resin composition to stand at 50°C for 72 hours. The viscosities before and after the treatment were determined by using E-type viscometer (determination temperature: 80°C for examples and comparative examples, 25°C for conventional example). The evaluation criteria are as follows.
ⓞ: the viscosity after the treatment being 1.5 times or less that of the viscosity before the treatment;
○: the viscosity after the treatment 3.0 times or less and exceeding 1.5 times that of the viscosity before the treatment;
Δ: the viscosity after the treatment 10 times or less and exceeding 3.0 times that of the viscosity before the treatment; and
× : the viscosity after the treatment exceeding 10 times that of the viscosity before the treatment.

Also, the determination of the viscosity using the E-type viscometer was carried out in the same manner as the method for determining the viscosities at 25°C and 80°C mentioned above.

It is clear from the results of the above Table 1 that the products of Examples have a longer operable time period and more excellent storage stability, as compared to those of the product of Conventional Example. Moreover, the products of Examples have excellent dischargeability and coating workability, and the resulting semiconductor device has excellent moisture tolerance reliability.

Also, the product of Comparative Example has a viscosity of less than 400 Pa•s at 25°C. Moreover, since an ordinary curing accelerator is used without further using a latent curing accelerator in the product of Comparative Example, it is seen that the operable time and the storage stability are liable to be poor.

### [Second Embodiment]

Examples and Comparative Examples of the Second Embodiment will be described hereinbelow.

The component A (solid epoxy resin), the component B (liquid phenolic resin) and the component C (latent curing accelerator) used in Examples and Comparative Examples of the Second Embodiment are as follows.

### [Component A, A2-1]:

A tetrafunctional naphthalenic epoxy resin (solid at 25°C, epoxy equivalence: 167 g/eq., softening point: 68°C), represented by the following formula:

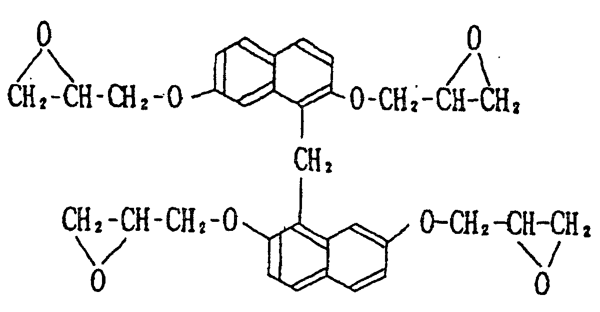

### [Component A, A2-2]:

Triphenylmethane epoxy resin (solid at 25°C, epoxy equivalence: 170 g/eq., softening point: 62°C) 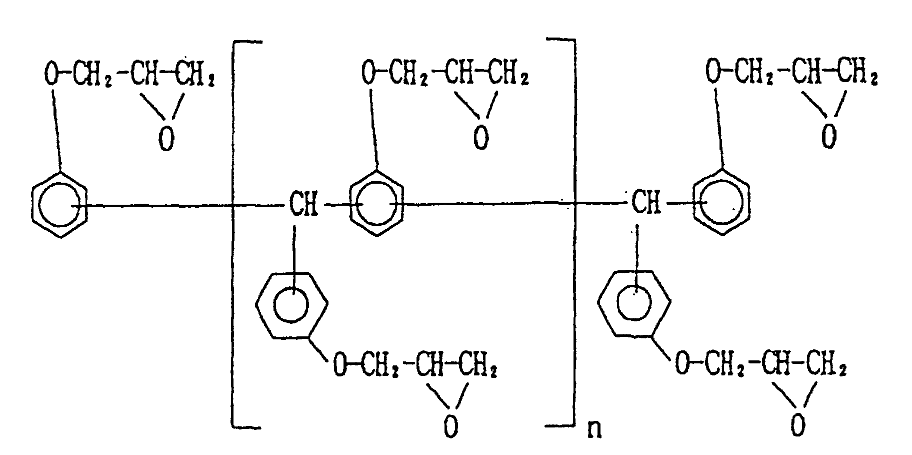 wherein n is nearly equal to 1.8.

### [Component B, B2-1]:

Allylated phenol novolak resin (liquid at 25°C, hydroxyl group equivalence: 135 g/eq., manufactured by Showa Kasei, "MEH-8005H")

### [Component C, C2-1]:

The same microcapsulated curing accelerator as that used as the curing accelerator C 1-1 in Examples and Comparative Example of the First Embodiment described above was used.

### [Component C, C2-2]:

MCE-9957 manufactured by NIPPON KAYAKU CO., LTD. (the same one as in C1-2 mentioned above)

### [Component C, C2-3]:

2-Ethyl-4-methylimidazole (the same one as in C1-3 mentioned above)

### Examples 2-1 to 2-3 and Comparative Example 2-1

The epoxy resin and the phenolic resin were formulated in proportions as shown in Table 2, and the mixture was blended at 110°C for 5 minutes to dissolve the entire solid content. Next, the temperature was adjusted to 65°C. Thereafter, a latent curing accelerator was added thereto, and homogeneously mixed for 2 minutes.

**Table 2**

| | Examples | | | Comp. Example |
|---|---|---|---|---|
| | 2-1 | 2-2 | 2-3* | 2-1 |
| A2-1 | 167 | - | - | - |
| A2-2 | - | 170 | 170 | 170 |
| B2-1 | 135 | 135 | 135 | 135 |
| C2-1 | 15.8 | 15.8 | - | - |
| C2-2 | - | - | 15.8 | - |
| C2-3 | - | - | - | 3.4 |
| Viscosity, Pa•s | | | | |
| at 25°C | 4560 | solid | solid | solid |
| at 80°C | 1.3 | 1.5 | 1.6 | 7 |
| Glass Transition Temperature (°C) | 130 | 128 | 126 | 140 |
| Storage Stability | ⓞ | ⓞ | ⓞ | × |
| Dischargeability and Coating Workability | ⓞ | ⓞ | ⓞ | ⓞ |
| Operable Time | ⓞ | ⓞ | ○ | × |

| | | | | |
|---|---|---|---|---|
| *Reference Example, not according to the invention | | | | |

With respect to each of the resulting resin compositions, the same evaluations as in the First Embodiment described above were made. The results are shown together in Table 2.

It is clear from the results of the above Table 2 that the products of Examples have a longer operable time period and more excellent storage stability, as compared to those of the product of Conventional Example. Moreover, the products of Examples have excellent dischargeability and coating workability, and the resulting semiconductor device has excellent moisture tolerance reliability. Especially, since the specified microcapsulated curing accelerator is used as a latent curing accelerator in the products of Examples 2-1 and 2-2, the operable time is very long and the storage stability is excellent, as compared to those in which the commercially available microcapsulated curing accelerator is used.

On the other hand, since the curing accelerator which is not a latent curing accelerator is used in the product of Comparative Example, it is seen that the operable time is shortened, and the viscosity greatly changes during storage.

### [Third Embodiment]

Examples and Comparative Examples of the Third Embodiment will be described hereinbelow.

The component A (solid epoxy resin), the component B (solid phenolic resin) and the component C (latent curing accelerator) used in Examples and Comparative Examples of the Third Embodiment are as follows.

### [Component A, A3-1]:

A crystalline epoxy resin (solid at 25°C, epoxy equivalence: 174 g/eq., melting point: 79°C), represented by the following formula:

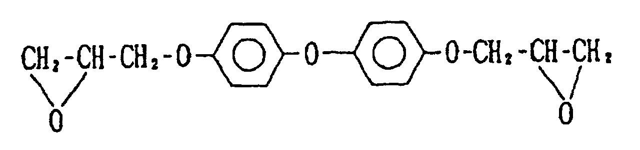

### [Component A, A3-2]:

A crystalline epoxy resin (solid at 25°C, epoxy equivalence: 173 g/eq., melting point: 145°C), represented by the following formula:

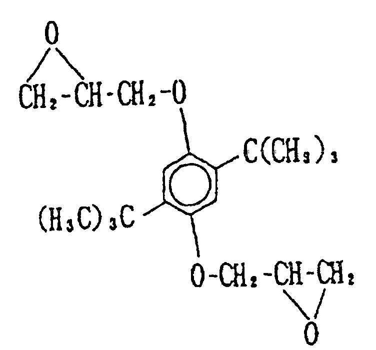

### [Component A, A3-3]:

A crystalline epoxy resin (solid at 25°C, epoxy equivalence: 195 g/eq., melting point: 105°C, manufactured by Yuka Shell), represented by the following formula:

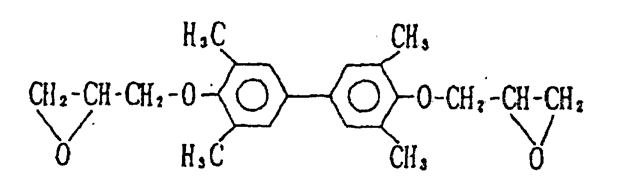

### [Component A, A3-4]:

A crystalline epoxy resin (solid at 25°C, epoxy equivalence: 190 g/eq., melting point: 78°C), represented by the following formula:

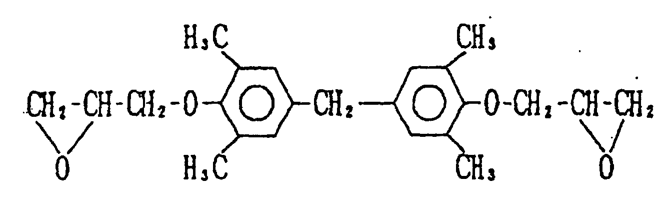

### [Component A, A3-5]:

Triphenylmethane epoxy resin (solid at 25°C, epoxy equivalence: 170 g/eq., softening point: 62°C) 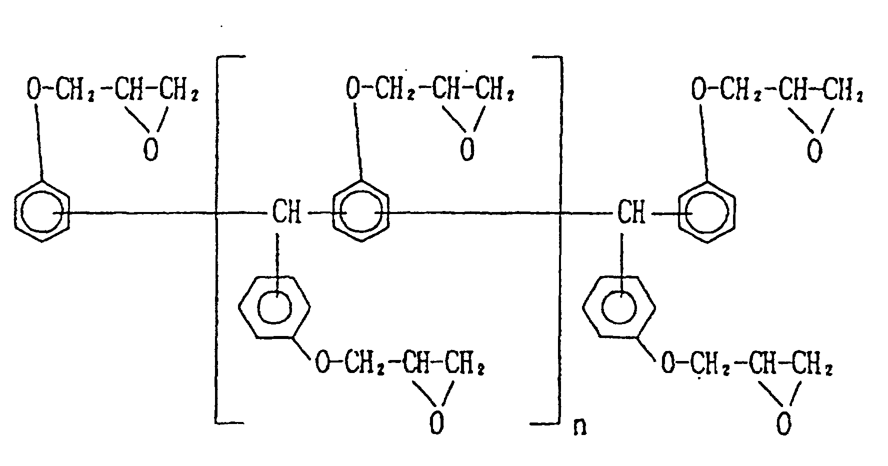 wherein n is nearly equal to 1.8.

### [Component A, A3-6]:

A tetrafunctional naphthalenic epoxy resin (solid at 25°C, epoxy equivalence: 167 g/eq., softening point: 68°C), represented by the following formula:

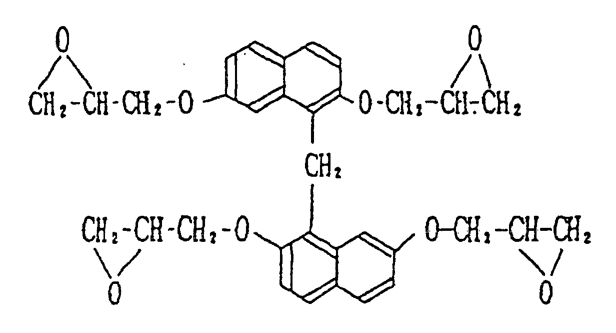

### [Component B, B3-1]:

A mixture of a trifunctional phenolic resin and a tetrafunctional phenolic resin (ratio of each peak area to entire peak area: about 65 / about 30, as determined by liquid chromatography, solid at 25°C, melting point: 132°C, manufactured by Honshu Chemical Industry Co., Ltd., MHD-244LG)

### [Component B, B3-2]:

A trifunctional phenolic resin (solid at 25°C, purity 98%, melting point: 94°C), represented by the following formula:

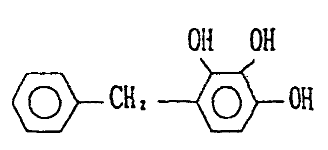

### [Component B, B3-3]:

A phenolic resin (solid at 25°C), represented by the following formula:

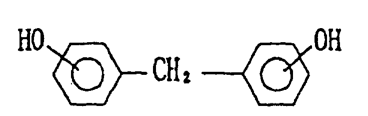

### [Component C, C3-1]:

The same microcapsulated curing accelerator as that used as the curing accelerator C1-1 in the First Embodiment described above was used.

### [Component C, C3-2]:

MCE-9957 manufactured by NIPPON KAYAKU CO., LTD. (the same one as in C1-2 mentioned above)

### [Component C, C3-3]:

2-Ethyl-4-methylimidazole (the same one as in C1-3 mentioned above)

### Examples 3-1, 3-3 and 3-5

The epoxy resin and the phenolic resin were formulated in proportions as shown in Table 3, and the mixture was blended at 150°C for 10 minutes to dissolve the entire solid content. Next, the temperature was adjusted to 75°C. Thereafter, a latent curing accelerator was added thereto, and homogeneously mixed for 2 minutes.

### Examples 3-2 and 3-4 and Comparative Example 3-1

The epoxy resin and the phenolic resin were formulated in proportions as shown in Table 3, and the mixture was blended at 130°C for 10 minutes to dissolve the entire solid content. Next, the temperature was adjusted to 65°C. Thereafter, a latent curing accelerator was added thereto, and homogeneously mixed for 2 minutes.

**Table 3**

| | Examples | | | | | Comp. Example |
|---|---|---|---|---|---|---|
| | 3-1 | 3-2 | 3-3 | 3-4 | 3-5* | 3-1 |
| A3-1 | 174 | - | - | - | 174 | - |
| A3-2 | - | 173 | - | - | - | 173 |
| A3-3 | - | 195 | - | - | - | 195 |
| A3-4 | - | 190 | - | - | - | 190 |
| A3-5 | - | - | 170 | - | - | - |
| A3-6 | - | - | - | 167 | - | - |
| B3-1 | 92 | - | 92 | - | 92 | - |
| B3-2 | - | 242 | - | - | - | 242 |
| B3-3 | - | - | - | 99 | - | - |
| C3-1 | 10.7 | 28.3 | 10.7 | 11.6 | - | - |
| C3-2 | - | - | - | - | 10.7 | - |
| C3-3 | - | - | - | - | - | 4.8 |
| Viscosity, Pa•s | | | | | | |
| at 25°C | 500 | 9200 | solid | solid | 600 | solid |
| at 80°C | 0.1 | 0.3 | 200 | 180 | 0.15 | 3 |
| Glass Transition Temperature (°C) | 130 | 128 | 180 | 190 | 131 | 140 |
| Storage Stability | ⓞ | ⓞ | ⓞ | ⓞ | ○ | × |
| Dischargeability and Coating Workability | ⓞ | ⓞ | Δ | Δ | ⓞ | ⓞ |
| Operable Time | ⓞ | ⓞ | ⓞ | ⓞ | ○ | × |

| | | | | | | |
|---|---|---|---|---|---|---|
| *Reference Example, not according to the invention | | | | | | |

With respect to each of the resulting resin compositions obtained in Examples and Comparative Example, the same evaluations as in the First Embodiment described above were made. The results are shown together in Table 3.

It is clear from the results of the above Table 3 that the products of Examples have a longer operable time period and more excellent storage stability, as compared to those of the product of Conventional Example. Moreover, the products of Examples have excellent dischargeability and coating workability, and the resulting semiconductor device has excellent moisture tolerance reliability. Especially, since the specified microcapsulated curing accelerator is used as a latent curing accelerator in the products of Examples 3-1 to 3-4, the operable time is very long and the storage stability is especially excellent.

On the other hand, since the curing accelerator which is not a latent curing accelerator is used in the product of Comparative Example 3-1, it is seen that the operable time is shortened, and the storage stability is impaired.

As described above, the resin composition of the present invention comprises an epoxy resin (the component A), a phenolic resin (the component B), and a latent curing accelerator (the component C), wherein the resin composition is a solid at 25°C, or a fluid having a specified viscosity range at each temperature of 25°C and 80°C. Therefore, as compared to the conventional liquid encapsulating material, the resin composition has a longer operable time, and more excellent storage stability. Moreover, even if the resin composition were a solid or semi-solid at room temperature, since the viscosity of the resin composition is dramatically lowered at a relatively low temperature of 40° to 80°C or so, and can be liquefied, the resin composition has excellent dischargeability and coating workability. Especially since the resin composition of the present invention is a solid or semi-solid at an ambient temperature, the resin composition can be freely handled at room temperature without curing after encapsulation in a semiconductor element or a wiring printed substrate. Therefore, the wiring printed substrate and the semiconductor element can be connected by coating the resin composition to a semiconductor wafer, a matrix-like wiring printed substrate or the like; thereafter cutting into individual semiconductor elements or wiring circuit substrate, and fusing the wiring circuit substrate with the semiconductor element by means of heat-and-pressure bonding with a flip chip bonder.

Moreover, when the microcapsulated curing accelerator having a core/shell structure comprising a core portion made of a curing accelerator and a specified shell portion, wherein the core portion is coated with the shell portion, is used as the latent curing accelerator (the component C), the resin composition comprising the microcapsulated curing accelerator has a very long operable time, so that the resin composition has an advantage that it is especially excellent in the storage stability.

## Claims

1. A resin composition for sealing a semiconductor device comprising:
(A) an epoxy resin;
(B) a phenolic resin; and
(C) a latent curing accelerator, which is a microcapsulated curing accelerator comprising a core made of a curing agent and, formed thereon, a shell comprising a polymer having urea bonding,
wherein the resin composition is a solid at 25°C or has a viscosity of not less than 400 Pa•s at 25°C and of not more than 200 Pa•s at 80°C.

2. The resin composition according to claim 1, wherein the component (A) is a liquid or solid epoxy resin and the component (B) is a liquid or solid phenolic resin.

3. The resin composition according to claim 1 or 2, wherein the component (B) is a polyfuncnonal phenolic resin.

4. The resin composition according to any one of claims 1 to 3, wherein the latent curing accelerator has a property that a resin composition comprising the latent curing accelerator has a viscosity at 80°C after treatment of 10 times or less than the viscosity before treatment, wherein the treatment comprises allowing the resin composition to stand in an atmosphere of 50°C for 72 hours.

5. A semiconductor device comprising:
a wiring circuit substrate;
plural connecting electrodes;
a semiconductor element mounted on the wiring circuit substrate via the plural connecting electrodes; and
a sealing resin layer formed with the resin composition of any one of claims 1 to 4,
wherein a gap between the wiring circuit substrate and the semiconductor element is sealed by the sealing resin layer.

6. The semiconductor device according to claim 5, wherein the sealing resin layer is formed by a step of:
(a) filling in a gap and curing the resin composition, or
(b) placing in a gap and curing a sheet-like product of the resin composition.

7. A semiconductor device comprising:
a wiring circuit substrate;
a semiconductor element mounted on the wiring circuit substrate, wherein the wiring circuit substrate and the semiconductor element are electrically connected; and
an encapsulation resin layer formed with the resin composition any one of claims 1 to 4, wherein the semiconductor element is incorporated in the encapsulation resin layer, thereby encapsulating the periphery of the semiconductor element.

8. The semiconductor device according to claim 7 produced by the steps comprising:
placing the semiconductor elements on the wiring circuit substrate, and electrically connecting the wiring circuit substrate with the semiconductor elements, and
feeding and curing the resin composition onto the semiconductor-mounted surface of the wiring circuit substrate.

9. A mounted structure for a semiconductor device comprising:
an external substrate for mounting;
a semiconductor device mounted on the external substrate; and
a sealing resin layer formed with the resin composition of any one of claims 1 to 4
wherein a gap between the external substrate for mounting and the semiconductor device is sealed by the sealing resin layer.

10. A semiconductor wafer comprising plural semiconductor elements arranged with projected electrodes on one side of the wafer, and a sealing resin layer having a given thickness made of the resin composition of any one of claims 1 to 4 the sealing resin layer is formed on the projected electrode-arranged side such that at least a tip end of the projected electrodes is exposed from the sealing resin layer.

11. The semiconductor wafer according to claim 10, wherein the sealing resin layer is formed by printing through an aperture of a mask.

12. A semiconductor device comprising:
an external substrate for mounting;
a semiconductor element individually obtained by cutting the semiconductor wafer of claim 10 or 11, wherein the external substrate and the semiconductor element are electrically connected by heat-and-pressure fusing or solder reflow in a state where a resin layer-forming side of the semiconductor element faces the external substrate; and
a sealing resin layer formed between the semiconductor element and the external substrate by thermally curing the resin layer.

13. A semiconductor device comprising:
a matrix-like wiring circuit substrate comprising individual wiring circuits;
plural semiconductor elements mounted on the wiring circuit substrate; and
an encapsulation resin layer formed with the resin composition of any one of claims 1 to 4 on the entire plural semiconductor elements, wherein the semiconductor element is incorporated in the encapsulation resin layer, thereby encapsulating the periphery of the semiconductor element.

## Patentansprüche

1. Harzzusammensetzung für das Versiegeln eines Halbleiterbauelements, die umfasst:
(A) ein Epoxyharz;
(B) ein Phenolharz; und
(C) einen latenten Härtungsbeschleuniger, welcher ein mikroverkapselter Härtungsbeschleuniger ist, der einen aus einem Härter hergestellten Kern und darauf ausgebildet eine Hülle umfasst, die ein Polymer mit Harnstoffbindung enthält,
wobei die Harzzusammensetzung bei 25°C ein Feststoff ist oder eine Viskosität von nicht weniger als 400 Pa·s bei 25°C und nicht mehr als 200 Pa·s bei 80°C besitzt.

2. Harzzusammensetzung gemäss Anspruch 1, wobei die Komponente (A) ein flüssiges oder festes Epoxyharz ist und die Komponente (B) ein flüssiges oder festes Phenolharz ist.

3. Harzzusammensetzung gemäss Anspruch 1 oder 2, wobei die Komponente (B) ein polyfunktionelles Phenolharz ist.

4. Harzzusammensetzung gemäss mindestens einem der Ansprüche 1 bis 3, wobei der latente Härtungsbeschleuniger die Eigenschaft besitzt, dass eine Harzzusammensetzung, welche den latenten Härtungsbeschleuniger enthält, nach der Behandlung eine zehnfache Viskosität bei 80°C oder weniger der Viskosität vor der Behandlung besitzt, wobei die Behandlung einschliesst, dass man die Harzzusammensetzung bei 50°C für 72 Stunden stehen lässt.

5. Halbleiterbauelement, das umfasst:
ein Drahtschaltungssubstrat;
mehrere Verbindungselektroden;
ein auf dem Drahtschaltungssubstrat über die mehreren Verbindungselektroden montiertes Halbleiterelement; und
eine Versiegelungsharzschicht, die mit der Harzzusammensetzung von mindestens einem der Ansprüche 1 bis 4 ausgebildet wird, wobei ein Zwischenraum zwischen dem Drahtschaltungssubstrat und dem Halbleiterelement durch die Versiegelungsharzschicht versiegelt wird.

6. Halbleiterbauelement gemäss Anspruch 5, wobei die Versiegelungsharzschicht gebildet ist durch einen der folgenden Schritte:'
(a) Einfüllen in einen Zwischenraum und Aushärten der Harzzusammensetzung oder
(b) Anordnen eines blattartigen Produkts der Harzzusammensetzung in einen Zwischenraum und Aushärten.

7. Halbleiterbauelement, das umfasst:
ein Drahtschaltungssubstrat;
ein auf dem Drahtschaltungssubstrat montiertes Halbleiterelement, wobei das Drahtschaltungssubstrat und das Halbleiterelement elektrisch verbunden sind; und
eine mit der Harzzusammensetzung gemäss mindestens einem der Ansprüche 1 bis 4 ausgebildete Einkapselungsharzschicht, wobei das Halbleiterelement in die Einkapselungsharzschicht eingebaut ist, wodurch die Umgebung des Halbleiterelements verkapselt wird.

8. Halbleiterbauelement gemäss Anspruch 7, das durch die folgenden Schritte hergestellt wird:
Anordnen der Halbleiterelemente auf dem Drahtschaltungssubstrat und elektrisches Verbinden des Drahtschaltungssubstrats mit den Halbleiterelementen und
Zufuhr und Aushärten der Harzzusammensetzung auf die Oberfläche des Drahtschaltungssubstrats mit montiertem Halbleiter.

9. Montierte Struktur für ein Halbleiterbauelement, die umfasst:
ein externes Substrat für das Montieren;
ein auf dem externen Substrat montiertes Halbleiterbauelement; und
eine mit der Harzzusammensetzung gemäss mindestens einem der Ansprüche 1 bis 4 ausgebildete Versiegelungsharzschicht, wobei ein Zwischenraum zwischen dem externen Substrat für das Montieren und dem Halbleiterbauelement mit der Versiegelungsharzschicht versiegelt wird.

10. Halbleiterwafer, der mehrere Halbleiterelemente, die mit vorstehenden Elektroden auf einer Seite des Wafers angeordnet sind, und eine Versiegelungsharzschicht mit einer gegebenen Dicke, die aus der Harzzusammensetzung gemäss mindestens einem der Ansprüche 1 bis 4 ausgebildet ist, umfasst, wobei die Versiegelungsharzschicht auf der Seite mit darauf angeordneten hervorstehenden Elektroden ausgebildet ist, so dass mindestens ein Spitzenende der vorstehenden Elektroden von der Versiegelungsharzschicht frei liegt.

11. Halbleiterwafer gemäss Anspruch 10, wobei die Versiegelungsharzschicht ausgebildet ist durch Drucken durch eine Apertur einer Maske.

12. Halbleiterbauelement, das umfasst:
ein externes Substrat für das Montieren;
ein Halbleiterelement, das jeweils erhalten wird durch Schneiden des Halbleiterwafers von Anspruch 10 oder 11, wobei das externe Substrat und das Halbleiterelement elektrisch verbunden sind, durch Verschmelzen unter Druck und Wärme oder Reflow-Löten in einem Zustand, in dem die Seite des Halbleiterelements zur Ausbildung der Harzschicht dem externen Substrat gegenüberliegt; und
eine Versiegelungsharzschicht, die zwischen dem Halbleiterelement und dem externen Substrat durch thermisches Aushärten der Harzschicht ausgebildet ist.

13. Halbleiterbauelement, das umfasst:
ein matrixartiges Drahtschaltungssubstrat, das einzelne Drahtschaltungen umfasst;
mehrere auf dem Drahtschaltungssubstrat montierte Halbleiterelemente; und
eine Einkapselungsharzschicht, die mit der Harzzusammensetzung gemäss mindestens einem der Ansprüche 1 bis 4 auf den gesamten mehreren Halbleiterelementen ausgebildet ist, wobei das Halbleiterelement in die Einkapselungsharzschicht eingebaut wird, wodurch die Umgebung des Halbleiterelements eingekapselt wird.

## Revendications

1. Composition de résine pour sceller un dispositif semi-conducteur comprenant :
(A) une résine époxy ;
(B) une résine phénolique ; et
(C) un accélérateur de durcissement latent, qui est un accélérateur de durcissement microencapsulé comprenant un coeur fait d'un agent de durcissement et, formé dessus, une coque comprenant un polymère ayant une liaison urée,
dans laquelle la composition de résine est un solide à 25 °C ou a une viscosité de pas moins de 400 Pa·s à 25 °C et de pas plus de 200 Pa·s à 80 °C.

2. Composition de résine selon la revendication 1, dans laquelle le composant (A) est une résine époxy liquide ou solide et le composant (B) est une résine phénolique liquide ou solide.

3. Composition de résine selon la revendication 1 ou 2, dans laquelle le composant (B) est une résine phénolique polyfonctionnelle.

4. Composition de résine selon l'une quelconque des revendications 1 à 3, dans laquelle l'accélérateur de durcissement latent a une propriété qu'une composition de résine comprenant l'accélérateur de durcissement latent a une viscosité à 80 °C après traitement de 10 fois ou moins la viscosité avant traitement, où le traitement comprend de laisser la composition de résine reposer dans une atmosphère de 50 °C pendant 72 heures.

5. Dispositif semi-conducteur comprenant :
un substrat de circuit imprimé ;
plusieurs électrodes de connexion ;
un élément semi-conducteur monté sur le substrat de circuit imprimé via les plusieurs électrodes de connexion ; et
une couche de résine de scellage formée avec la composition de résine de l'une quelconque des revendications 1 à 4, où un espace entre le substrat de circuit imprimé et l'élément semi-conducteur est scellé par la couche de résine de scellage.

6. Dispositif semi-conducteur selon la revendication 5, dans lequel la couche de résine de scellage est formée par une étape de :
(a) remplissage d'un espace et le durcissement de la composition de résine, ou
(b) placement dans un espace et le durcissement d'un produit en forme de feuille de la composition de résine.

7. Dispositif semi-conducteur comprenant :
un substrat de circuit imprimé ;
un élément semi-conducteur monté sur le substrat de circuit imprimé, où le substrat de circuit imprimé et l'élément semi-conducteur sont électriquement connectés ; et
une couche de résine d'encapsulation formée avec la composition de résine de l'une quelconque des revendications 1 à 4, où l'élément semi-conducteur est incorporé dans la couche de résine d'encapsulation, encapsulant de ce fait la périphérie de l'élément semi-conducteur.

8. Dispositif semi-conducteur selon la revendication 7 produit par les étapes comprenant :
de placer les éléments semi-conducteurs sur le substrat de circuit imprimé, et de connecter électriquement le substrat de circuit imprimé avec les éléments semi-conducteurs, et
de fournir et durcir la composition de résine sur la surface du substrat de circuit imprimé sur laquelle est monté le semi-conducteur.

9. Structure montée pour un dispositif semi-conducteur comprenant :
un substrat externe pour montage ;
un dispositif semi-conducteur monté sur le substrat externe ; et
une couche de résine de scellage formée avec la composition de résine de l'une quelconque des revendications 1 à 4, où un espace entre le substrat externe pour montage et le dispositif semi-conducteur est scellé par la couche de résine de scellage.

10. Plaquette semi-conductrice comprenant plusieurs éléments semi-conducteurs arrangés avec des électrodes projetées sur un côté de la plaquette, et une couche de résine de scellage ayant une épaisseur donnée faite de la composition de résine de l'une quelconque des revendications 1 à 4, la couche de résine de scellage est formée sur le côté arrangé avec les électrodes projetées tel qu'au moins un bout d'extrémité des électrodes projetées est exposée à partir de la couche de résine de scellage.

11. Plaquette semi-conductrice selon la revendication 10, dans laquelle la couche de résine de scellage est formée en imprimant à travers une ouverture d'un masque.

12. Dispositif semi-conducteur comprenant :
un substrat externe pour montage ;
un élément semi-conducteur obtenu individuellement en coupant la plaquette semi-conductrice selon la revendication 10 ou 11, où le substrat externe et l'élément semi-conducteur sont électriquement connectés par fusion par chaleur-et-pression ou par soudage à refusion dans un état où un côté de formation de couche de résine de l'élément semi-conducteur fait face au substrat externe ; et
une couche de résine de scellage formée entre l'élément semi-conducteur et le substrat externe en durcissant thermiquement la couche de résine.

13. Dispositif semi-conducteur comprenant :
un substrat de circuit imprimé du genre matrice comprenant des circuits imprimés individuels ;
plusieurs éléments semi-conducteurs montés sur le substrat de circuit imprimé ; et
une couche de résine d'encapsulation formée avec la composition de résine de l'une quelconque des revendications 1 à 4 sur les plusieurs éléments semi-conducteurs entiers, où l'élément semi-conducteur est incorporé dans la couche de résine d'encapsulation, encapsulant de ce fait la périphérie de l'élément semi-conducteur.
